# EUROPÄISCHE PATENTSCHRIFT

(11) **EP 2 852 727 B1**
(45) Veröffentlichungstag und Bekanntmachung des Hinweises auf die Patenterteilung: **21.03.2018**
(21) Anmeldenummer: 13723479.5
(22) Anmeldetag: 15.05.2013
(51) Int. Cl.: F24F 5/00, F25B 27/00, E06B 3/67, F25B 21/04, H01L 31/048, F24F 13/18

(54) **VORRICHTUNG ZUM KÜHLEN EINES RAUMS**
APPARATUS FOR COOLING A ROOM
DISPOSITIF DE REFROIDISSEMENT D'UNE ENCEINTE

(30) Priorität: 21.05.2012 DE 102012208406
(43) Veröffentlichungstag der Anmeldung: 01.04.2015
(73) Patentinhaber: PR Germany GmbH, 50678 Köln (DE)
(72) Erfinder: LICHT, Michael, 51588 Nümbrecht (DE); REINECKE, Peter, 51588 Nümbrecht (DE)
(74) Vertreter: Tongbhoyai, Martin
(86) Internationale Anmeldenummer: PCT/EP2013/059987
(87) Internationale Veröffentlichungsnummer: WO 2013/174685

(56) Entgegenhaltungen:
- EP-A2- 0 028 820
- EP-A2- 1 486 637
- WO-A1-2005/111517
- WO-A2-2011/048595
- WO-A2-2011/126547
- DE-A1- 3 801 989
- DE-A1- 10 341 169
- DE-U1-202008 000 678
- FR-A1- 2 769 786
- FR-A1- 2 816 042
- JP-A- 2001 132 193
- US-A- 3 064 110
- US-A- 4 733 504
- US-A- 5 852 284
- US-A1- 2005 166 495
- US-A1- 2011 056 924
- US-A1- 2011 100 591

## Beschreibung

Die Erfindung betrifft eine Vorrichtung zum Kühlen eines Raums.
Aus dem Stand der Technik ist es bekannt, dass ein Raum, beispielsweise ein Raum in einem Gebäude, mittels einer Klimaeinrichtung gekühlt und/oder geheizt werden kann. Eine gewünschte Temperatur im Raum ist dabei mittels einer Steuereinheit einstellbar. Die Klimaeinrichtung kühlt oder heizt den Raum derart, bis die eingestellte gewünschte Temperatur im Raum erzielt ist.

Ferner ist es aus dem Stand der Technik bekannt, einen Raum eines Gebäudes mit mindestens einem Fenster zu versehen, so dass der Raum mit Tageslicht ausgeleuchtet werden kann.
Aus der JP 2002129846 A ist eine Glasstruktur für ein Gebäude bekannt. Ferner ist dieser Druckschrift zu entnehmen, dass ein Peltier-Element an einem Fensterrahmen angeordnet wird. In einem Doppelglasfenster weist das Peltier-Element eine Leitung auf, die mit einer Luftschicht der Doppelverglasung kommuniziert. Die Luft wird demnach gekühlt.

Ferner ist aus der JP 2001132193 A ein Gebäudeteil für ein Fenster bekannt, wobei ein Peltiermodul zum Kühlen vorgesehen ist, welches in einer Isolierungslücke zwischen zwei Platten angeordnet ist.
Der vorbeschriebene Stand der Technik weist den Nachteil auf, dass es sich bei den bekannten Systemen nicht um autarke Systeme handelt. Die bekannten Systeme werden mit Versorgungseinheiten betrieben, die mit Strom versorgt werden, welcher von Energieversorgern zur Verfügung gestellt wird. Zudem haben Überlegungen ergeben, dass die Kühl- oder Wärmeleistung der bekannten Systeme möglicherweise nicht ausreicht, um einen Raum ausreichend zu kühlen oder zu erwärmen.

Aus der US 2005/0166495 A1 ist ein Fensterflügel für Türen oder Fenster bekannt, die eine Vorrichtung zur Verhinderung von Tauwasser aufweist. Ferner ist aus der DE 20 2008 000 678 U1 eine Scheibe für einen Fensterflügel und einen Türflügel bekannt. An einem Rand ist ein Solarzellenstreifen angeordnet. Aus der DE 103 41 169 A1 ist ein photovoltaik-integriertes Doppelglasmodul bekannt. Ferner wird hinsichtlich des Standes der Technik auch auf die FR 2 769 786 A1 sowie die JP 2001132193 hingewiesen.

Aus der WO 2005/111517 A1 ist eine gattunsgemässe Kühleinrichtung bekannt, die Solarenergie zum Heizen oder Kühlen eines Raums verwendet.
Der Erfindung liegt die Aufgabe zugrunde, eine Vorrichtung zum Kühlen eines Raums anzugeben, die zum einen autark betrieben werden kann und zum anderen eine ausreichende Kühl- und Wärmeleistung zur Verfügung stellt. Erfindungsgemäß wird diese Aufgabe durch eine Vorrichtung mit den Merkmalen des Anspruchs 1 gelöst. Ein erfindungsgemäßes Lichteintrittssystem, beispielsweise ein Fenstersystem, ist durch die Merkmale des Anspruchs 15 gegeben. Weitere Merkmale der Erfindung ergeben sich aus der nachfolgenden Beschreibung, den beigefügten Ansprüchen und/oder den beigefügten Figuren.
Die erfindungsgemäße Vorrichtung zum Kühlen eines Raums ist insbesondere als Fenstervorrichtung ausgebildet, beispielsweise als Fenstervorrichtung für einen Raum eines Gebäudes. Es wird aber explizit darauf hingewiesen, dass die Verwendung der erfindungsgemäßen Vorrichtung nicht auf Gebäude beschränkt ist. Vielmehr ist die erfindungsgemäße Vorrichtung zum Kühlen eines jeden Raums geeignet, beispielsweise eines Innenraums eines Kraftfahrzeugs, eines Innenraums eines Zugs oder eines Innenraums eines Schiffs. Die erfindungsgemäße Vorrichtung weist mindestens einen Rahmen auf, der beispielsweise an einem Gebäude zur Befestigung eines Fensters angeordnet ist. Ferner weist die erfindungsgemäße Vorrichtung mindestens eine erste Lichtdurchlasseinrichtung und mindestens eine zweite Lichtdurchlasseinrichtung auf. Wie weiter unten noch näher erläutert, ist/sind die erste Lichtdurchlasseinrichtung und oder die zweite Lichtdurchlasseinrichtung als Fenster ausgebildet. Die Erfindung ist auch nicht auf zwei Lichtdurchlasseinrichtungen eingeschränkt. Vielmehr kann bei der Erfindung jede geeignete Anzahl an Lichtdurchlasseinrichtungen vorgesehen sein.

Die erste Lichtdurchlasseinrichtung und die zweite Lichtdurchlasseinrichtung sind an dem Rahmen angeordnet. Zwischen der ersten Lichtdurchlasseinrichtung und der zweiten Lichtdurchlasseinrichtung ist mindestens ein erster Zwischenraum ausgebildet. In diesem ersten Zwischenraum ist mindestens ein wärmeleitfähiges Medium angeordnet ist, beispielsweise ein Gas. Hierauf wird weiter unten noch näher eingegangen. Bei der erfindungsgemäßen Vorrichtung ist nun mindestens ein Kühlelement derart am Rahmen angeordnet, dass es mit dem im Zwischenraum angeordneten wärmeleitfähigen Medium in Kontakt steht. Ferner weist die Vorrichtung mindestens eine mittels Solarstrom betriebene Spannungsversorgungseinheit auf, die mit dem Kühlelement verbunden ist.

Aufgrund der mit Solarstrom betriebenen Spannungsversorgungseinheit ist es möglich, dass die Vorrichtung autark betrieben werden kann, so dass eine Energieversorgung durch ein Energieversorgungsunternehmen nicht zwingend notwendig ist. Ferner ist der Betrieb der erfindungsgemäßen Vorrichtung umweltfreundlich. Auch hat sich überraschenderweise gezeigt, dass die erfindungsgemäße Vorrichtung eine gute und ausreichende Kühl- und Wärmeleistung zur Verfügung stellt. Das Kühlelement wirkt mit dem wärmeleitfähigen Medium zusammen. Es wird ein derart guter Wärmeaustausch zwischen dem Kühlelement und dem wärmeleitfähigen Medium bereitgestellt, dass ein Raum über das wärmeleitfähige Medium ausreichend gut gekühlt wird. Der Raum ist beispielsweise an einer ersten Seite der ersten Lichtdurchlasseinrichtung angeordnet. Das wärmeleitfähige Medium ist beispielsweise an einer zweiten Seite der ersten Lichtdurchlasseinrichtung angeordnet und/oder strömt dort entlang. Es kommt zu einem Wärmeaustausch zwischen dem wärmeleitfähigen Medium, der ersten Lichtdurchlasseinrichtung und dem Raum.

Bei einer weiteren Ausführungsform der Erfindung ist es zusätzlich vorgesehen, die Spannungsversorgungseinheit mit Energie zu versorgen, die durch ein Energieversorgungsunternehmen zur Verfügung gestellt wird. Bei dieser Ausführungsform ist daher nicht unbedingt der Betrieb der Spannungsversorgungseinheit mit Solarstrom vorgesehen. Dies kann bei allen hier diskutierten Ausführungsbeispielen vorgesehen sein.

Bei einer weiteren Ausführungsform ist es zusätzlich vorgesehen, dass die erfindungsgemäße Vorrichtung mindestens eine dritte Lichtdurchlasseinrichtung aufweist, beispielsweise ein Fenster. Dies wird weiter unten näher erläutert. Die dritte Lichtdurchlasseinrichtung ist an dem Rahmen angeordnet. Ferner ist zwischen der dritten Lichtdurchlasseinrichtung und der zweiten Lichtdurchlasseinrichtung mindestens ein zweiter Zwischenraum ausgebildet. In dem zweiten Zwischenraum ist mindestens ein isolierendes Medium angeordnet, welches die Wärmeleitung zwischen der dritten Lichtdurchlasseinrichtung und der zweiten Lichtdurchlasseinrichtung reduziert. Hierdurch wird ein ungewolltes Abkühlen oder eine ungewollte Erwärmung eines Raums verringert. Hierzu wird auch auf weiter unten verwiesen. Zusätzlich hierzu ist es vorgesehen, dass an der dritten Lichtdurchlasseinrichtung und/oder der zweiten Lichtdurchlasseinrichtung mindestens eine Beschichtung zur Reduzierung von Wärmestrahlung angeordnet ist. Beispielsweise ist eine erste Beschichtung an der zum zweiten Zwischenraum gerichteten Seite der dritten Lichtdurchlasseinrichtung angeordnet. Ferner ist beispielsweise eine zweite Beschichtung an der zum zweiten Zwischenraum gerichteten Seite der zweiten Lichtdurchlasseinrichtung angeordnet. Als Material von mindestens einer der vorgenannten Beschichtungen ist beispielsweise Gold oder Platin vorgesehen. Die Erfindung ist aber auf diese Materialien nicht eingeschränkt. Vielmehr ist jedes geeignete Material verwendbar. Mindestens eine der vorgenannten Beschichtungen ist beispielsweise vorgesehen, um Licht einer bestimmten Wellenlänge oder beispielsweise eines bestimmten Wellenlängenbereichs des in den Raum einstrahlenden Lichts zu reflektieren. Beispielsweise wird der mittlere Infrarot-Bereich des Lichts reflektiert. Bei Verwendung der ersten Beschichtung wird das Licht der bestimmten Wellenlänge oder des bestimmten Wellenlängenbereichs derart reflektiert, dass es nicht in den zweiten Zwischenraum gelangt. Ferner wird bei Verwendung der zweiten Beschichtung das Licht der bestimmten Wellenlänge oder des bestimmten Wellenlängenbereichs derart reflektiert, dass es nicht in den ersten Zwischenraum gelangt. Über das wärmeleitfähige Medium ist aber stets gewährleistet, dass ein ausreichender Wärmeaustausch zwischen der ersten Lichtdurchlasseinrichtung und einem Raum stattfindet, so dass eine ausreichende Kühlung für den Raum zur Verfügung gestellt wird.

Bei einer Ausführungsform der erfindungsgemäßen Vorrichtung ist es zusätzlich vorgesehen, dass die Spannungsversorgungseinheit mindestens eine Solar-Einheit umfasst. Beispielsweise ist die Solar-Einheit als Photovoltaikeinrichtung ausgebildet, die mindestens eine Solarzelle oder zahlreiche Solarzellen aufweist. Die Anordnung der Solar-Einheit ist dabei beliebig wählbar. Beispielsweise kann die Solar-Einheit an dem Rahmen der erfindungsgemäßen Vorrichtung angeordnet sein. Ein weiteres Ausführungsbeispiel sieht es vor, die Solar-Einheit auf dem Dach eines Gebäudes anzuordnen, an dem die erfindungsgemäße Vorrichtung angeordnet ist. Weitere mögliche Ausführungsbeispiele sind weiter unten beschrieben.

So ist es bei einer weiteren Ausführungsform der erfindungsgemäßen Vorrichtung zusätzlich vorgesehen, dass die Solar-Einheit an der dritten Lichtdurchlasseinrichtung angeordnet ist. Beispielsweise ist es vorgesehen, dass die dritte Lichtdurchlasseinrichtung mindestens eine erste Seite und mindestens eine zweite Seite aufweist, wobei die erste Seite an dem zweiten Zwischenraum angrenzt, wobei die zweite Seite nicht an dem zweiten Zwischenraum angrenzt, und wobei die Solar-Einheit an der ersten Seite angeordnet ist. Insbesondere ist es vorgesehen, dass die Solar-Einheit folienartig ausgebildet ist, die an der dritten Lichtdurchlasseinrichtung oder der ersten Seite der dritten Lichtdurchlassenrichtung angeordnet ist. Dies erfolgt beispielsweise durch Aufkleben der folienartigen Solar-Einheit. Bei einem wiederum weiteren Ausführungsbeispiel ist es vorgesehen, dass die Solar-Einheit zumindest teilweise transparent ausgebildet ist. Hierbei ist von Vorteil, dass ein an der erfindungsgemäßen Vorrichtung angrenzender Raum ausreichend gut mit Licht, beispielsweise Tageslicht, ausgeleuchtet ist. Es wird explizit darauf hingewiesen, dass die Erfindung nicht auf die vorgenannten Ausführungsbeispiele der Solar-Einheit eingeschränkt ist. Vielmehr ist jede geeignete Solar-Einheit verwendbar. Auch sehen weitere Ausführungsbeispiele der Erfindung es vor, die Solar-Einheit an der zweiten Seite der dritten Lichtdurchlasseinrichtung anzuordnen.

Bei einer noch weiteren Ausführungsform der erfindungsgemäßen Vorrichtung ist es zusätzlich vorgesehen, dass die Solar-Einheit an der zweiten Lichtdurchlasseinrichtung angeordnet ist. Beispielsweise ist es vorgesehen, dass die zweite Lichtdurchlasseinrichtung mindestens eine dritte Seite und mindestens eine vierte Seite aufweist, wobei die dritte Seite an dem ersten Zwischenraum angrenzt und wobei die vierte Seite nicht an dem ersten Zwischenraum angrenzt. Die Solar-Einheit ist an der vierten Seite angeordnet. Insbesondere ist es vorgesehen, dass die Solar-Einheit folienartig ausgebildet ist, die an der dritten Lichtdurchlasseinrichtung oder der vierten Seite der dritten Lichtdurchlassenrichtung angeordnet ist. Dies erfolgt beispielsweise durch Aufkleben der folienartigen Solar-Einheit. Bei einem wiederum weiteren Ausführungsbeispiel ist es vorgesehen, dass die Solar-Einheit zumindest teilweise transparent ausgebildet ist. Auch hier ist von Vorteil, dass ein an der erfindungsgemäßen Vorrichtung angrenzender Raum ausreichend gut mit Licht, beispielsweise Tageslicht, ausgeleuchtet ist. Es wird auch explizit darauf hingewiesen, dass die Erfindung nicht auf die vorgenannten Ausführungsbeispiele der Solar-Einheit eingeschränkt ist. Vielmehr ist jede geeignete Solar-Einheit verwendbar. Auch sehen weitere Ausführungsbeispiele der Erfindung es vor, die Solar-Einheit an der dritten Seite der zweiten Lichtdurchlasseinrichtung anzuordnen.

Es wird explizit darauf hingewiesen, dass die Solar-Einheit auch an Seiten der Lichtdurchlasseinrichtungen angeordnet werden kann, die zu einem Zwischenraum gerichtet sind.

Bei einer wiederum weiteren Ausführungsform der erfindungsgemäßen Vorrichtung ist es zusätzlich vorgesehen, dass die Solar-Einheit in dem ersten Zwischenraum angeordnet ist. Alternativ oder zusätzlich ist es vorgesehen, dass die Solar-Einheit in dem zweiten Zwischenraum angeordnet ist. Beispielsweise sind mehrere Solar-Einheiten an der erfindungsgemäßen Vorrichtung angeordnet. Bei einer Ausführungsform der erfindungsgemäßen Vorrichtung ist die Solar-Einheit eine erste Solar-Einheit. Ferner weist die erfindungsgemäße Vorrichtung mindestens eine zweite Solar-Einheit auf. Die erste Solar-Einheit und die zweite Solar-Einheit sind in dem zweiten Zwischenraum derart beabstandet zueinander angeordnet, dass mindestens ein dritter Zwischenraum zwischen der ersten Solar-Einheit und der zweiten Solar-Einheit gebildet ist. Licht tritt in den dritten Zwischenraum ein und trifft dann auf die erste Solar-Einheit und/oder die zweite Solar-Einheit. Bei dieser Ausführungsform sind die erste Solar-Einheit und/oder die zweite Solar-Einheit als plattenförmige Einheiten ausgebildet. Im dritten Zwischenraum ist beispielsweise eine optische Einheit (beispielsweise ein Glas) angeordnet, so dass beispielsweise Tageslicht, welches in die erfindungsgemäße Vorrichtung eintritt, von der optischen Einheit in Richtung der erste Solar-Einheit und/oder der zweiten Solar-Einheit geleitet wird. Diese Ausführungsform gewährleistet eine besonders gute Transparenz der Vorrichtung. Eine Person, die sich in einem Raum befindet, der mit dieser Ausführungsform der erfindungsgemäßen Vorrichtung ausgestattet ist, wird den Eindruck erlangen, dass der Raum stets und ausreichend mit Tageslicht versorgt ist. Ferner ist die Transparenz derart gut, dass die Person gute Sicht auf die Umgebung hat, welche durch die erfindungsgemäße Vorrichtung sichtbar ist.

Bei einer Ausführungsform der erfindungsgemäßen Vorrichtung ist es zusätzlich vorgesehen, dass zwischen dem Rahmen und dem ersten Zwischenraum mindestens eine Begrenzung angeordnet ist, an welcher der Rahmen an den ersten Zwischenraum angrenzt. Ferner ist das Kühlelement mit mindestens einer Kühleinheit verbunden, die in den ersten Zwischenraum ragt. Beispielsweise umfasst die Kühleinheit eine Kühlrippe oder mehrere Kühlrippen, beispielsweise bis zu sechs Kühlrippen. Die Erfindung ist aber auf eine bestimmte Anzahl der Kühlrippen nicht eingeschränkt. Vielmehr kann bei der Erfindung jegliche Anzahl an Kühlrippen vorgesehen sein. Ferner sieht dieses Ausführungsbeispiel vor, dass das Kühlelement derart an dem Rahmen angeordnet ist, dass das Kühlelement die Begrenzung nicht berührt. Diese Ausführungsform weist den Vorteil auf, dass das Kühlelement für einen Betrachter nicht sichtbar ist. Es ist praktisch in dem Rahmen eingelassen.

Bei einer noch weiteren Ausführungsform der erfindungsgemäßen Vorrichtung ist es zusätzlich vorgesehen, dass das Kühlelement als Peltier-Element ausgebildet ist. Die Erfindung ist aber nicht auf ein derartiges Kühlelement eingeschränkt. Vielmehr ist jedes geeignete Kühlelement bei der Erfindung verwendbar.

Bei einer wiederum weiteren Ausführungsform der erfindungsgemäßen Vorrichtung ist es zusätzlich vorgesehen, dass der Rahmen als Teilrahmen ausgebildet ist. Dabei wird unter einem Teilrahmen ein Rahmen verstanden, der nicht in sich geschlossen ist. Beispielsweise weist ein Teilrahmen bei seitlicher Betrachtung eine U-förmige Ausbildung auf. Bei einer alternativen Ausführungsform ist es vorgesehen, dass der Rahmen als Vollrahmen ausgebildet ist. Dabei weist ein Vollrahmen bei seitlicher Betrachtung die Form eines Rechtecks oder eines Quadrats auf.

Bei einer Ausführungsform der erfindungsgemäßen Vorrichtung ist es zusätzlich vorgesehen, dass die Vorrichtung mindestens eines der folgenden Merkmale aufweist:
- das wärmeleitfähige Medium ist als Gas ausgebildet,
- das wärmeleitfähige Medium ist Helium, oder
- das wärmeleitfähige Medium ist Wasserstoff.

Helium und Wasserstoff haben eine deutlich höhere Wärmeleitfähigkeit als Luft. Die Verwendung von Helium als wärmeleitfähiges Medium wird aber bevorzugt.

Bei einer weiteren Ausführungsform der erfindungsgemäßen Vorrichtung ist es zusätzlich vorgesehen, dass die Vorrichtung mindestens eines der folgenden Merkmale aufweist:
- das isolierende Medium ist als Gas ausgebildet,
- das isolierende Medium ist Argon, oder
- das isolierende Medium ist Krypton.

Es wird explizit darauf hingewiesen, dass die Erfindung nicht auf die vorgenannten Ausführungsbeispiele eines isolierenden Mediums eingeschränkt ist. Vielmehr ist jedes geeignete isolierende Medium bei der Erfindung einsetzbar, beispielsweise Luft. Bei weiteren Ausführungsbeispielen wird der erste Zwischenraum und/oder der zweite Zwischenraum unter Vakuum gehalten.

Bei einer noch weiteren Ausführungsform der erfindungsgemäßen Vorrichtung ist es zusätzlich vorgesehen, dass die Vorrichtung mindestens eines der folgenden Merkmale aufweist:
- die erste Lichtdurchlasseinrichtung ist als Fenster ausgebildet,
- die erste Lichtdurchlasseinrichtung ist als Fenster aus Glas gebildet,
- die erste Lichtdurchlasseinrichtung ist als Fenster aus Kunststoff gebildet,
- die zweite Lichtdurchlasseinrichtung ist als Fenster ausgebildet,
- die zweite Lichtdurchlasseinrichtung ist als Fenster aus Glas gebildet, oder
- die zweite Lichtdurchlasseinrichtung ist als Fenster aus Kunststoff gebildet.

Ferner ist es bei einer weiteren Ausführungsform der erfindungsgemäßen Vorrichtung zusätzlich vorgesehen, dass die Vorrichtung mindestens eines der folgenden Merkmale aufweist:
- die dritte Lichtdurchlasseinrichtung ist als Fenster ausgebildet,
- die dritte Lichtdurchlasseinrichtung ist als Fenster aus Glas gebildet, oder
- die dritte Lichtdurchlasseinrichtung ist als Fenster aus Kunststoff gebildet.

Bei einem weiteren Ausführungsbeispiel der erfindungsgemäßen Vorrichtung ist es zusätzlich vorgesehen, mehrere Solar-Einheiten zu verwenden. Beispielsweise sind mindestens zwei Solar-Einheiten vorgesehen, beispielsweise mehr als drei Solar-Einheiten. Die Solar-Einheiten sind an mindestens einer der vorgenannten Lichtdurchlasseinrichtungen angeordnet. Dabei ist es beispielsweise vorgesehen, dass jeweils zwei der mehreren Solar-Einheiten beabstandet zueinander angeordnet sind. Dies ermöglicht, dass beispielsweise Tageslicht ungehindert durch den Bereich zwischen zwei der mehreren Solar-Einheiten treten kann. Bei einem wiederum weiteren Ausführungsbeispiel ist es zusätzlich vorgesehen, dass mindestens eine der vorgenannten Lichtdurchlasseinrichtungen bis zu 100%, oder bis zu 90%, oder bis zu 80%, oder bis zu 70%, oder bis zu 60%, oder bis zu 50%, oder bis zu 40% oder bis zu 30 %, oder bis zu 20% oder bis zu 10% mit mindestens einer Solar-Einheit oder mit mehreren Solar-Einheiten, beispielsweise zwei Solar-Einheiten, bedeckt ist. Somit sind einige Bereiche der Lichtdurchlasseinrichtung nicht mit Solar-Einheiten bedeckt, so dass in diesen Bereichen beispielsweise Tageslicht ungehindert in die erfindungsgemäße Vorrichtung und anschließend in einen Raum treten kann.

Die Erfindung betrifft auch ein Lichteintrittsystem, insbesondere ein System, welches als Fenstervorrichtung ausgebildet ist (Fenstersystem). Dieses weist mindestens eine Vorrichtung mit einem der zuvor genannten oder noch weiter unten genannten Merkmale oder einer Kombination aus mindestens zwei der zuvor genannten oder noch weiter unten genannten Merkmale auf.

Die Erfindung wird nun anhand von Ausführungsbeispielen mittels Figuren näher erläutert. Dabei zeigen
- Figur 1: eine erste Ausführungsform einer erfindungsgemäßen Vorrichtung zum Kühlen eines Raums;
- Figur 2: eine zweite Ausführungsform einer erfindungsgemäßen Vorrichtung zum Kühlen eines Raums;
- Figur 3: eine dritte Ausführungsform einer erfindungsgemäßen Vorrichtung zum Kühlen eines Raums; sowie
- Figur 4: eine vierte Ausführungsform einer erfindungsgemäßen Vorrichtung zum Kühlen eines Raums.

Nachfolgend wird die Erfindung anhand von Ausführungsbeispielen beschrieben, die zum Kühlen eines Raums eines Gebäudes eingesetzt werden. Die Ausführungsbeispiele sind an Fenstersystemen angeordnet. Wie oben aber bereits erwähnt, ist die Verwendung der erfindungsgemäßen Vorrichtung nicht auf Gebäude beschränkt. Vielmehr ist die erfindungsgemäße Vorrichtung zum Kühlen eines jeden Raums geeignet, beispielsweise eines Innenraums eines Kraftfahrzeugs, eines Innenraums eines Zugs oder eines Innenraums eines Schiffs.

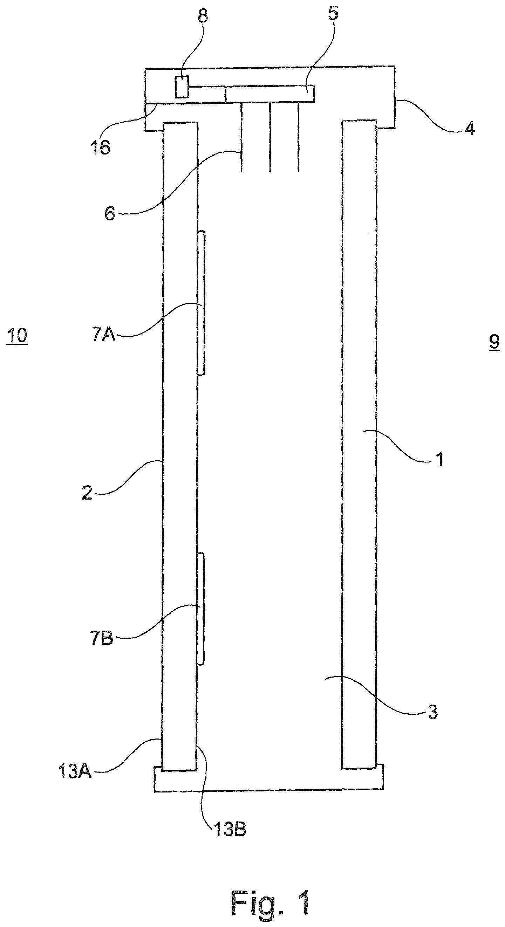

**Figur 1** zeigt ein erstes Ausführungsbeispiel der erfindungsgemäßen Vorrichtung. Dieses ist als Fenstersystem für einen Raum 9 ausgebildet und ist an einer Wand eines Gebäudes (nicht dargestellt) angeordnet. Das Fenstersystem erlaubt die Sicht auf eine Umgebung 10 vom Raum 9 aus.
Die erfindungsgemäße Vorrichtung weist eine erste Lichtdurchlasseinrichtung in Form eines ersten Fensters 1 und eine zweite Lichtdurchlasseinrichtung in Form eines zweiten Fensters 2 auf. Beispielsweise ist/sind das erste Fenster 1 und/oder das zweite Fenster 2 aus Glas oder Kunststoff ausgebildet. Das erste Fenster 1 uns das zweite Fenster 2 sind derart an einem Rahmen 4 angeordnet, dass das erste Fenster 1 und das zweite Fenster 2 zueinander beabstandet sind. Zwischen dem ersten Fenster 1 und dem zweiten Fenster 2 ist ein erster Zwischenraum 3 ausgebildet. Der erste Zwischenraum 3 wird durch den Rahmen 4 abgedichtet. Im ersten Zwischenraum 3 ist ein wärmeleitfähiges Medium, beispielsweise ein Gas, angeordnet. Bei dem hier dargestellten Ausführungsbeispiel wird Helium als wärmeleitfähiges Medium verwendet. Alternativ hierzu kann auch jedes weitere geeignete Gas verwendet werden.

Im Rahmen 4 ist in einer Ausnehmung ein Kühlelement in Form eines Peltier-Elements 5 angeordnet. Das Peltier-Element 5 ist derart im Rahmen 4 angeordnet, dass es für einen Betrachter, der sich im Raum 9 befindet, nicht sichtbar ist. Das Peltier-Element 5 ist mit Kühlrippen 6 verbunden, welche in den ersten Zwischenraum 3 ragen und mit dem wärmeleitfähigen Medium in Kontakt sind.
Das zweite Fenster 2 weist eine Außenseite 13A und eine Innenseite 13B auf, wobei die Innenseite 13B an den ersten Zwischenraum 3 angrenzt. Auf der Innenseite 13B sind eine erste Solar-Einheit 7A und eine zweite Solar-Einheit 7B angeordnet. Beispielsweise sind die erste Solar-Einheit 7A und die zweite Solar-Einheit 7B folienartig ausgebildet und auf der Innenseite 13B befestigt. Es wird explizit darauf hingewiesen, dass die erste Solar-Einheit 7A und/oder die zweite Solar-Einheit 7B nicht auf eine folienartige Ausbildung eingeschränkt ist. Vielmehr ist jede geeignete Ausbildung der Solar-Einheiten verwendbar. Insoweit wird auf weiter oben verwiesen.

Sowohl die erste Solar-Einheit 7A als auch die zweite Solar-Einheit 7B sind mit einer Steuer- und Kontrolleinheit 8 verbunden. Licht, welches von der Umgebung 10 auf die erste Solar-Einheit 7A und die zweite Solar-Einheit 7B fällt, wird in Strom umgewandelt und an die Steuer-und Kontrolleinheit 8 weitergeleitet. Mit dem auf diese Weise gewonnenen Strom wird das Peltier-Element 5 betrieben.

Aufgrund der mit Solarstrom betriebenen Spannungsversorgungseinheit in Form der Steuer- und Kontrolleinheit 8 ist es möglich, dass die erfindungsgemäße Vorrichtung autark und umweltfreundlich betrieben werden kann. Auch hat es sich überraschenderweise gezeigt, dass die erfindungsgemäße Vorrichtung eine gute und ausreichende Kühl- und Wärmeleistung zur Verfügung stellt. Das Peltier-Element 5 wirkt mit dem wärmeleitfähigen Medium in Form des Heliums zusammen. Es besteht ein guter Wärmeaustausch zwischen dem Peltier-Element 5 und dem Helium. Der Raum 9, der an dem ersten Fenster 1 angeordnet ist, wird aufgrund eines Wärmetausches zwischen dem Helium, das an dem ersten Fenster 1 angeordnet ist und/oder dort entlang strömt, und dem ersten Fenster 1 ausreichend gut gekühlt. Es kommt somit zu einem Wärmeaustausch zwischen dem Helium, dem ersten Fenster 1 und dem Raum 9.

Das Peltier-Element 5 ist mittels eines Leitungsblechs 16, das beispielsweise aus Aluminium gebildet ist, derart an dem Rahmen 4 angeordnet, dass es zu einem Wärmetausch zwischen dem Peltier-Element 5, dem Leitungsblech 16, dem Rahmen 4 und der Umgebung 10 kommt. Die durch den beschriebenen Prozess des Wärmetausches zwischen dem Raum 9, dem ersten Fenster 1, dem Helium und dem Peltier-Element 5 transportierte Wärme wird somit an die Umgebung 10 wieder abgegeben.

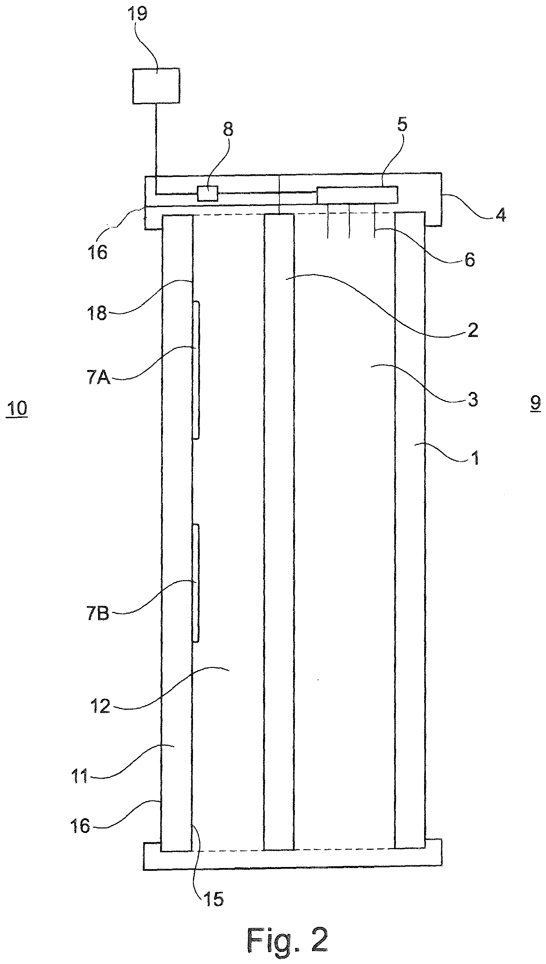

Das Ausführungsbeispiel der **Figur 2** beruht auf dem Ausführungsbeispiel gemäß der **Figur 1****.** Gleiche Bauteile sind daher mit gleichen Bezugszeichen versehen.

Im Unterschied zum Ausführungsbeispiel gemäß der **Figur 1** weist das Ausführungsbeispiel gemäß der **Figur 2** den Unterschied auf, dass an dem Rahmen 4 eine dritte Lichtdurchlasseinrichtung in Form eines dritten Fensters 11 angeordnet ist. Zwischen dem zweiten Fenster 2 und dem dritten Fenster 11 ist ein zweiter Zwischenraum 12 ausgebildet. Der zweite Zwischenraum 12 wird durch den Rahmen 4 abgedichtet. Im zweiten Zwischenraum 12 ist ein isolierendes Medium, beispielsweise ein Gas, angeordnet. Bei dem hier dargestellten Ausführungsbeispiel wird Argon oder Krypton als isolierendes Medium verwendet. Alternativ hierzu kann auch jedes weitere geeignete Gas verwendet werden, beispielsweise Luft. Auch kann der zweite Zwischenraum 12 unter Vakuum gesetzt werden.
Das dritte Fenster 11 weist eine erste Seite 15 und eine zweite Seite 16 auf. Die erste Seite 15 ist zum zweiten Zwischenraum 12 gerichtet. Hingegen ist die zweite Seite 16 zur Umgebung 10 gerichtet. An der ersten Seite 15 sind die erste Solar-Einheit 7A und die zweite Solar-Einheit 7B angeordnet.
Bei dieser Ausführungsform dient das isolierende Medium im zweiten Zwischenraum 12 zur Reduzierung der Wärmeleitung zwischen dem zweiten Fenster 2 und dem dritten Fenster 11. Beispielsweise wird Wärme, die durch Einfall von Licht auf der ersten Solar-Einheit 7A oder der zweiten Solar-Einheit 7B entsteht, verringert zu dem zweiten Fenster 2 transportiert. Zusätzlich hierzu ist es vorgesehen, dass an dem dritten Fenster 11 und/oder an dem zweiten Fenster 2 mindestes eine Beschichtung zur Reduzierung von Wärmestrahlung angeordnet ist. Wie oben bereits erläutert, ist beispielsweise eine erste Beschichtung 18 an der zum zweiten Zwischenraum 12 gerichteten ersten Seite 15 des dritten Fensters 11 angeordnet. Ferner ist beispielsweise eine zweite Beschichtung (nicht dargestellt) an der zum zweiten Zwischenraum 12 gerichteten Seite des zweiten Fensters 2 angeordnet. Als Material der Beschichtungen ist beispielsweise Gold oder Platin vorgesehen. Die Erfindung ist aber auf diese Materialien nicht eingeschränkt. Vielmehr ist jedes geeignete Material verwendbar. Mindestens eine der vorgenannten Beschichtungen ist beispielsweise vorgesehen, um Licht einer bestimmten Wellenlänge oder beispielsweise eines bestimmten Wellenlängenbereichs zu reflektieren. Beispielweise wird der mittlere Infrarot-Anteil des Lichts reflektiert (insbesondere ein Bereich mit einer Wellenlänge von 3 µm bis 50 µm).

Das Helium im ersten Zwischenraum 3 stellt sicher, dass ein ausreichender Wärmeaustausch zwischen dem ersten Fenster 1 und dem Raum 9 stattfindet, so dass eine ausreichende Kühlung des Raums 9 zur Verfügung gestellt wird.

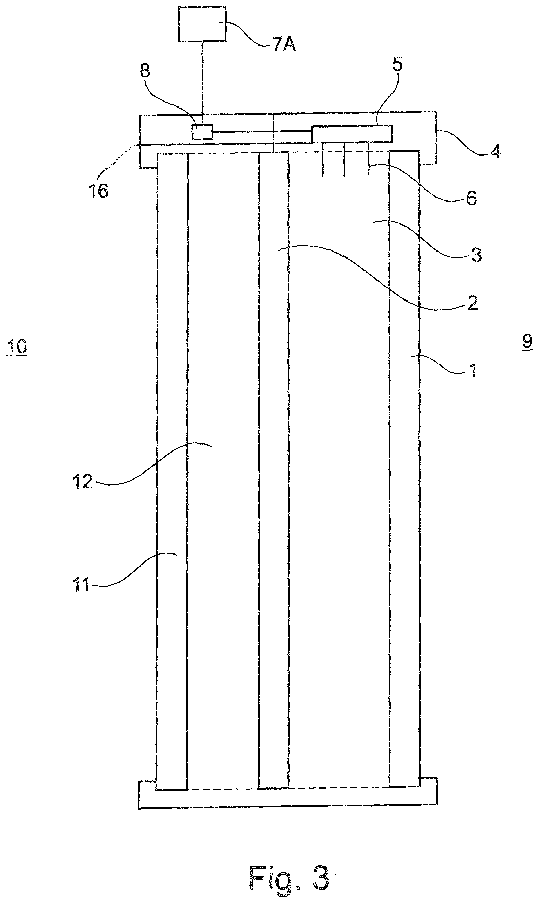

Das Ausführungsbeispiel der **Figur 3** beruht auf dem Ausführungsbeispiel gemäß der **Figur 2****.** Gleiche Bauteile sind daher mit gleichen Bezugszeichen versehen. Im Unterschied zum Ausführungsbeispiel gemäß der **Figur 2** weist das Ausführungsbeispiel gemäß der **Figur 3** den Unterschied auf, dass die erste Solar-Einheit 7A an einem unterschiedlichen Ort als die weiteren Einheiten der erfindungsgemäßen Vorrichtung angeordnet ist, beispielsweise auf dem Dach des Gebäudes.

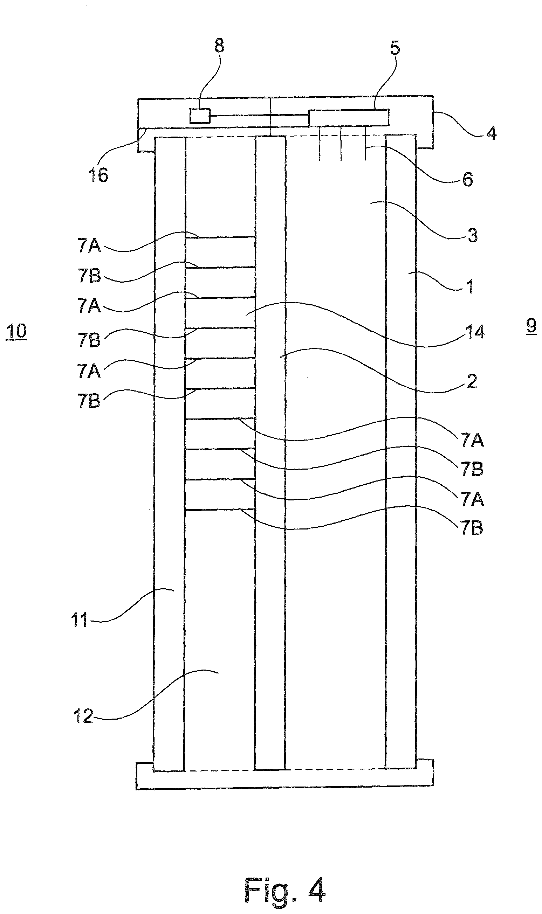

Das Ausführungsbeispiel der **Figur 4** beruht ebenfalls auf dem Ausführungsbeispiel gemäß der **Figur 2****.** Gleiche Bauteile sind daher mit gleichen Bezugszeichen versehen. Im Unterschied zum Ausführungsbeispiel gemäß der **Figur 2** weist das Ausführungsbeispiel gemäß der **Figur 4** den Unterschied auf, dass mehrere erste Solar-Einheiten 7A und mehrere zweite Solar-Einheiten 7B vorgesehen sind. Die mehreren ersten Solar-Einheiten 7A und mehreren zweiten Solar-Einheiten 7B sind plattenförmig ausgebildet. Sie weisen beispielsweise eine Dicke von 0,5mm bis 2 cm auf. Ferner sind jeweils eine erste Solar-Einheit 7A und eine zweite Solar-Einheit 7B in dem zweiten Zwischenraum 12 derart beabstandet zueinander angeordnet, dass mindestens ein dritter Zwischenraum 14 zwischen der jeweiligen ersten Solar-Einheit 7A und der jeweiligen zweiten Solar-Einheit 7B gebildet ist. Licht tritt in den dritten Zwischenraum 14 ein und trifft dann auf die erste Solar-Einheit 7A und/oder die zweite Solar-Einheit 7B. Im dritten Zwischenraum 14 ist beispielsweise eine optische Einheit (beispielsweise ein Glas) angeordnet, so dass Tageslicht, welches in die erfindungsgemäße Vorrichtung von der Umgebung 10 eintritt, von der optischen Einheit in Richtung der erste Solar-Einheit 7A und/oder der zweiten Solar-Einheit 7B geleitet wird. Wie oben erwähnt, gewährleistet diese Ausführungsform eine besonders gute Transparenz der Vorrichtung.

Jede der hier beschriebenen Ausführungsformen kann eine Bedienungseinheit aufweisen. Diese ist beispielhaft in **Figur 2** mit dem Bezugszeichen 19 versehen. Es wird darauf hingewiesen, dass jedes weitere hier beschriebene Ausführungsbeispiel ebenfalls die Bedienungseinheit 19 aufweisen kann. Mittels der Bedienungseinheit 19 wird die erfindungsgemäße Vorrichtung gesteuert. Beispielsweise ist es vorgesehen, mittels der Bedienungseinheit 19 ein Kühlen des Raums 9 einzustellen. Die Bedienungseinheit 19 ist beispielsweise derart ausgelegt, dass eine Temperatur des Raums 9 regelbar ist. Die Temperatur des Raums 9 wird mit geeigneten Messfühlern gemessen. Sobald die Temperatur des Raums 9 einen mittels der Bedieneinheit 19 eingestellten Wert überschreitet, wird die erfindungsgemäße Vorrichtung derart gesteuert, dass durch Kühlen der eingestellte Wert der Temperatur im Raum 9 erzielt wird. Bei einer weiteren Ausführungsform der Erfindung ist es vorgesehen, dass die Bedieneinheit 19 eine Fernsteuerung umfasst.

### Bezugszeichenliste

- 1: erstes Fenster
- 2: zweites Fenster
- 3: erster Zwischenraum
- 4: Rahmen
- 5: Peltier-Element
- 6: Kühlrippen
- 7A: erste Solar-Einheit
- 7B: zweite Solar-Einheit
- 8: Steuer- und Kontrolleinheit (Spannungsversorgungseinheit)
- 9: Raum
- 10: Umgebung
- 11: drittes Fenster
- 12: zweiter Zwischenraum
- 13A: Außenseite
- 13B: Innenseite
- 14: dritter Zwischenraum
- 15: erste Seite
- 16: zweite Seite
- 17: Leitungsbleich
- 18: erste Beschichtung
- 19: Bedieneinheit

## Patentansprüche

1. Kühlvorrichtung zum Kühlen eines Raums (9) mit
- mindestens einem Rahmen (4),
- mindestens einer ersten Lichtdurchlasseinrichtung (1),
- mindestens einer zweiten Lichtdurchlasseinrichtung (2), wobei:
- die Kühlvorrichtung zum Kühlen eines Raums eines Gebäudes, eines Innenraums eines Kraftfahrzeugs, eines Innenraums eines Zugs oder eines Innenraums eines Schiffs vorgesehen ist,
- die erste Lichtdurchlasseinrichtung (1) und die zweite Lichtdurchlasseinrichtung (2) an dem Rahmen (4) angeordnet sind,
- zwischen der ersten Lichtdurchlasseinrichtung (1) und der zweiten Lichtdurchlasseinrichtung (2) mindestens ein erster Zwischenraum (3) ausgebildet ist,
- mindestens ein wärmeleitfähiges Medium in dem ersten Zwischenraum (3) angeordnet ist,
- mindestens ein Kühlelement (5) derart am Rahmen (4) angeordnet ist, dass es mit dem im Zwischenraum (3) angeordneten wärmeleitfähigen Medium in Kontakt steht, und wobei
- die Vorrichtung mindestens eine mittels Solarstrom betriebene Spannungsversorgungseinheit (8) aufweist, die mit dem Kühlelement (5) verbunden ist,
**dadurch gekennzeichnet, dass**
der erste Zwischenraum (3) durch den Rahmen (4) abgedichtet ist.

2. Vorrichtung nach Anspruch 1, wobei
- die Vorrichtung mindestens eine dritte Lichtdurchlasseinrichtung (11) aufweist,
- die dritte Lichtdurchlasseinrichtung (11) an dem Rahmen (4) angeordnet ist,
- zwischen der dritten Lichtdurchlasseinrichtung (11) und der zweiten Lichtdurchlasseinrichtung (2) mindestens ein zweiter Zwischenraum (12) ausgebildet ist, und wobei
- in dem zweiten Zwischenraum (12) mindestens ein isolierendes Medium angeordnet ist.

3. Vorrichtung nach Anspruch 1 oder 2, wobei die Spannungsversorgungseinheit (8) mindestens eine Solar-Einheit (7A, 7B) umfasst.

4. Vorrichtung nach Ansprüche 2 und 3, wobei die Vorrichtung mindestens eines der folgenden Merkmale aufweist:
- die Solar-Einheit (7A, 7B) ist an der dritten Lichtdurchlasseinrichtung (11) angeordnet;
- die dritte Lichtdurchlasseinrichtung (11) weist mindestens eine erste Seite (15) und mindestens eine zweite Seite (16) auf, wobei die erste Seite (15) an dem zweiten Zwischenraum (12) angrenzt, wobei die zweite Seite (16) nicht an dem zweiten Zwischenraum (12) angrenzt, und wobei die Solar-Einheit (7A, 7B) an der ersten Seite (15) angeordnet ist, oder
- die Solar-Einheit (7A, 7B) ist zumindest teilweise transparent ausgebildet.

5. Vorrichtung nach Anspruch 3, wobei die Vorrichtung mindestens eines der folgenden Merkmale aufweist:
- die Solar-Einheit (7A, 7B) ist an der zweiten Lichtdurchlasseinrichtung (2) angeordnet;
- die zweite Lichtdurchlasseinrichtung (2) weist mindestens eine dritte Seite (13B) und mindestens eine vierte Seite (13A) auf, wobei die dritte Seite (13B) an dem ersten Zwischenraum (3) angrenzt, wobei die vierte Seite (13A) nicht an dem ersten Zwischenraum (3) angrenzt, und wobei die Solar-Einheit (7A, 7B) an der vierten Seite (13B) angeordnet ist, oder
- die Solar-Einheit (7A, 7B) ist zumindest teilweise transparent ausgebildet.

6. Vorrichtung nach Anspruch 3, wobei die Solar-Einheit (7A, 7B) in dem ersten Zwischenraum (3) angeordnet ist.

7. Vorrichtung nach Anspruch 3, wobei die Solar-Einheit (7A, 7B) in dem zweiten Zwischenraum (12) angeordnet ist.

8. Vorrichtung nach Anspruch 7, wobei
- die Solar-Einheit (7A) eine erste Solar-Einheit ist,
- die Vorrichtung mindestens eine zweite Solar-Einheit (7B) aufweist,
- die erste Solar-Einheit (7A) und die zweite Solar-Einheit (7B) in dem zweiten Zwischenraum (12) derart beabstandet zueinander angeordnet sind, dass mindestens ein dritter Zwischenraum (14) zwischen der ersten Solar-Einheit (7A) und der zweiten Solar-Einheit (7B) derart gebildet ist, dass Licht durch den dritten Zwischenraum (14) auf die erste Solar-Einheit (7A) und/oder die zweite Solar-Einheit (7B) trifft.

9. Vorrichtung nach einem der vorangehenden Ansprüche, wobei
- zwischen dem Rahmen (4) und dem ersten Zwischenraum (3) mindestens eine Begrenzung angeordnet ist, an welcher der Rahmen (4) an den ersten Zwischenraum (3) angrenzt,
- das Kühlelement (5) mit mindestens einer Kühleinheit (6) verbunden ist, die in den ersten Zwischenraum (3) ragt, und wobei das Kühlelement (5) derart an dem Rahmen (4) angeordnet ist, dass das Kühlelement (5) die Begrenzung nicht berührt.

10. Vorrichtung nach einem der vorangehenden Ansprüche, wobei das Kühlelement als Peltier-Element (5) ausgebildet ist.

11. Vorrichtung nach einem der vorangehenden Ansprüche, wobei die Vorrichtung mindestens eines der folgenden Merkmale aufweist:
- das wärmeleitfähige Medium ist als Gas ausgebildet,
- das wärmeleitfähige Medium ist Helium, oder
- das wärmeleitfähige Medium ist Wasserstoff.

12. Vorrichtung nach einem der Ansprüche 2 bis 11, wobei die Vorrichtung mindestens eines der folgenden Merkmale aufweist:
- das isolierende Medium ist als Gas ausgebildet,
- das isolierende Medium ist Argon, oder
- das isolierende Medium ist Krypton.

13. Vorrichtung nach einem der vorangehenden Ansprüche, wobei die Vorrichtung mindestens eines der folgenden Merkmale aufweist:
- die erste Lichtdurchlasseinrichtung (1) ist als Fenster ausgebildet,
- die erste Lichtdurchlasseinrichtung (1) ist als Fenster aus Glas gebildet,
- die erste Lichtdurchlasseinrichtung (1) ist als Fenster aus Kunststoff gebildet,
- die zweite Lichtdurchlasseinrichtung (2) ist als Fenster ausgebildet,
- die zweite Lichtdurchlasseinrichtung (2) ist als Fenster aus Glas gebildet, oder
- die zweite Lichtdurchlasseinrichtung (2) ist als Fenster aus Kunststoff gebildet.

14. Vorrichtung nach einem der Ansprüche 2 bis 13, wobei die Vorrichtung mindestens eines der folgenden Merkmale aufweist:
- die dritte Lichtdurchlasseinrichtung (11) ist als Fenster ausgebildet,
- die dritte Lichtdurchlasseinrichtung (11) ist als Fenster aus Glas gebildet, oder
- die dritte Lichtdurchlasseinrichtung (11) ist als Fenster aus Kunststoff gebildet.

15. Lichteintrittsystem, insbesondere ein Fenstersystem, mit einer Vorrichtung nach mindestens einem der vorangehenden Ansprüche.

## Claims

1. Cooling device for cooling a room (9), comprising:
- at least one frame (4),
- at least one first light transmitting means (1),
- at least one second light transmitting means (2),
wherein
- the cooling device is intended for cooling a room of a building, an interior of a motor vehicle, an interior of a train or an interior of a ship,
- the first light transmitting means (1) and the second light transmitting means (2) are arranged on the frame (4),
- at least one first intermediate space (3) is formed between the first light transmitting means (1) and the second light transmitting means (2),
- at least one thermally conductive medium is arranged in the first intermediate space (3),
- at least one cooling element (5) is arranged on the frame (4) such that it is in contact with the thermally conductive medium arranged in the intermediate space (3), and wherein
- the device comprises at least one solar-powered power supply unit (8) connected to the cooling element (5),
**characterized in that**
the first intermediate space (3) is sealed by the frame (4).

2. Device according to claim 1, wherein
- the device comprises at least one third light transmitting means (11),
- the third light transmitting means (11) is arranged on the frame (4),
- at least one second intermediate space (12) is formed between the third light transmitting means (11) and the second light transmitting means (2), and wherein
- at least one insulating medium is arranged in the second intermediate space (12).

3. Device according to claim 1 or 2, wherein the power supply unit (8) comprises at least one solar unit (7A, 7B).

4. Device according to claims 2 and 3, wherein the device comprises at least one of the following features:
- the solar unit (7A, 7B) is arranged on the third light transmitting means (11);
- the third light transmitting means (11) has at least one first side (15) and at least one second side (16), wherein the first side (15) is adjacent to the second intermediate space (12), wherein the second side (16) is not adjacent to the second intermediate space (12), and wherein said solar unit (7A, 7B) is arranged on the first side (15), or
- the solar unit (7A, 7B) is at least partially transparent.

5. Device according to claim 3, wherein the device comprises at least one of the following features:
- the solar unit (7A, 7B) is arranged on the second light transmitting means (2);
- the second light transmitting means (2) has at least one third side (13B) and at least one fourth side (13A), wherein the third side (13B) is adjacent to the first intermediate space (3), wherein the fourth side (13A) is not adjacent to the first intermediate space (3), and wherein the solar unit (7A, 7B) is arranged on the fourth side (13A), or
- the solar unit (7A, 7B) is at least partially transparent.

6. Device according to claim 3, wherein the solar unit (7A, 7B) is arranged in the first intermediate space (3).

7. Device according to claim 3, wherein the solar unit (7A, 7B) is arranged in the second intermediate space (12).

8. Device according to claim 7, wherein
- the solar unit (7A) is a first solar unit,
- the device has at least a second solar unit (7B),
- the first solar unit (7A) and the second solar unit (7B) are arranged in the second intermediate space (12) at such a distance from one another that at least a third intermediate space (14) is formed between the first solar unit (7A) and the second solar unit (7B) such that light comes through the third intermediate space (14) and falls on the first solar unit (7A) and/or on the second solar unit (7B).

9. Device according to one of the preceding claims, wherein
- between the frame (4) and the first intermediate space (3), at least one limit is arranged at which the frame (4) adjoins the first intermediate space (3),
- the cooling element (5) is connected to at least one cooling unit (6) which projects into the first intermediate space (3), and wherein the cooling element (5) is arranged on the frame (4) in such a manner that the cooling element (5) does not touch the limit.

10. Device according to one of the preceding claims, wherein the cooling element is designed as a Peltier element (5).

11. Device according to one of the preceding claims, wherein the device comprises at least one of the following features:
- the thermally conductive medium is in the form of a gas;
- the thermally conductive medium is helium, or
- the thermally conductive medium is hydrogen.

12. Device according to one of claims 2 to 11, wherein the device comprises at least one of the following features:
- the insulating medium is in the form of a gas,
- the insulating medium is argon, or
- the insulating medium is krypton.

13. Device according to one of the preceding claims, wherein the device comprises at least one of the following features:
- the first light transmitting means (1) is designed as a window,
- the first light transmitting means (1) is designed as a window made of glass,
- the first light transmitting means (1) is designed as a window made of plastic,
- the second light transmitting means (2) is designed as a window,
- the second light transmitting means (2) is designed as a window made of glass, or
- the second light transmitting means (2) is designed as a window made of plastic.

14. Device according to one of claims 2 to 13, wherein the device comprises at least one of the following features:
- the third light transmitting means (11) is designed as a window,
- the third light transmitting means (11) is designed as a window made of glass, or
- the third light transmitting means (11) is designed as a window made of plastic.

15. Light entry system, in particular a window system, comprising a device according to at least one of the preceding claims.

## Revendications

1. Dispositif de refroidissement destiné à refroidir un espace (9), comprenant :
- au moins un cadre (4),
- au moins un premier dispositif de transmission de lumière (1),
- au moins un second dispositif de transmission de lumière (2),
dans lequel :
- le dispositif de refroidissement est prévu pour refroidir une pièce d'un immeuble, un espace intérieur d'un véhicule automobile, un espace intérieur d'un train ou d'un bateau,
- le premier dispositif de transmission de lumière (1) et le second dispositif de transmission de lumière (2) sont disposés contre le cadre (4),
- au moins un premier espace intermédiaire (3) est agencé entre le premier dispositif de transmission de lumière (1) et le second dispositif de transmission de lumière (2),
- au moins un fluide caloporteur est agencé dans le premier espace intermédiaire (3),
- au moins un élément de refroidissement (5) est disposé contre le cadre (4) de façon à être en contact avec le fluide caloporteur disposé dans l'espace intermédiaire (3), et dans lequel
- le dispositif comprend au moins une unité d'alimentation électrique (8) fonctionnant à l'énergie solaire, qui est reliée à l'élément de refroidissement (5),
**caractérisé en ce que**
le premier espace intermédiaire (3) est rendu étanche par le cadre (4).

2. Dispositif selon la revendication 1, dans lequel
- le dispositif comprend au moins un troisième dispositif de transmission de lumière (11),
- le troisième dispositif de transmission de lumière (11) est disposé contre le cadre (4),
- au moins un second espace intermédiaire (12) est agencé entre le troisième dispositif de transmission de lumière (11) et le second dispositif de transmission de lumière (2), et dans lequel
- au moins un fluide isolant est disposé dans le second espace intermédiaire (12).

3. Dispositif selon la revendication 1 ou 2, dans lequel l'unité d'alimentation électrique (8) comprend au moins une unité solaire (7A, 7B).

4. Dispositif selon la revendication 2 ou 3, le dispositif présentant au moins une des caractéristiques suivantes :
- l'unité solaire (7A, 7B) est disposée contre le troisième dispositif de transmission de lumière (11),
- le troisième dispositif de transmission de lumière (11) comprend au moins un premier côté (15) et au moins un second côté (16), le premier côté (15) étant contigu au second espace intermédiaire (12), le second côté (16) n'étant pas contigu au second espace intermédiaire (12) et l'unité solaire (7A, 7B) étant disposée sur le premier côté (15), ou
- l'unité solaire (7A, 7B) est conçue de façon à être au moins en partie transparente.

5. Dispositif selon la revendication 3, qui présente au moins une des caractéristiques suivantes :
- l'unité solaire (7A, 7B) est disposée contre le second dispositif de transmission de lumière (2),
- le second dispositif de transmission de lumière (2) comprend au moins un troisième côté (13B) et au moins un quatrième côté (13A), le troisième côté (13B) étant contigu au premier espace intermédiaire (3), le quatrième côté (13A) n'étant pas contigu au premier espace intermédiaire (3) et l'unité solaire (7A, 7B) est disposée sur le quatrième côté (13B), ou
- l'unité solaire (7A, 7B) est conçue de façon à être au moins en partie transparente.

6. Dispositif selon la revendication 3, dans lequel l'unité solaire (7A, 7B) est disposée dans le premier espace intermédiaire (3).

7. Dispositif selon la revendication 3, dans lequel l'unité solaire (7A, 7B) est disposée dans le second espace intermédiaire (12).

8. Dispositif selon la revendication 7, dans lequel
- l'unité solaire (7A) est une première unité solaire,
- le dispositif comprend au moins une seconde unité solaire (7B),
- la première unité solaire (7A) et la seconde unité solaire (7B) sont disposées dans le second espace intermédiaire (12) de façon espacée l'une de l'autre de telle manière qu'au moins un troisième espace intermédiaire (14) entre la première unité solaire (7A) et la seconde unité solaire (7B) est formé de sorte que la lumière passant à travers le troisième espace intermédiaire (14) rencontre la première unité solaire (7A) et/ou la seconde unité solaire (7B).

9. Dispositif selon l'une quelconque des revendications précédentes, dans lequel :
- au moins une délimitation est agencée entre le cadre (4) et le premier espace intermédiaire (3), au niveau de laquelle le cadre est contigu au premier espace intermédiaire (3), et
- l'élément de refroidissement (5) est relié à au moins une unité de refroidissement (6) qui fait saillie dans le premier espace intermédiaire (3), et dans lequel l'élément de refroidissement (5) est agencé sur le cadre (4) de telle sorte que l'élément de refroidissement (5) n'est pas en contact avec la délimitation.

10. Dispositif selon l'une quelconque des revendications précédentes, dans lequel l'élément de refroidissement est conçu sous forme d'un élément Peltier (5).

11. Dispositif selon l'une quelconque des revendications précédentes, qui présente au moins une des caractéristiques suivantes :
- le fluide caloporteur est un gaz,
- le fluide caloporteur est de l'hélium, ou
- le fluide caloporteur est de l'hydrogène.

12. Dispositif selon l'une quelconque des revendications 2 à 11, qui présente au moins une des caractéristiques suivantes :
- le fluide isolant est un gaz,
- le fluide isolant est de l'argon, ou
- le fluide isolant est du krypton.

13. Dispositif selon l'une quelconque des revendications précédentes, qui présente au moins une des caractéristiques suivantes :
- le premier dispositif de transmission de la lumière (1) est conçu sous forme d'une fenêtre,
- le premier dispositif de transmission de la lumière (1) est formé d'une fenêtre en verre,
- le premier dispositif de transmission de la lumière (1) est formé d'une fenêtre en matière plastique,
- le second dispositif de transmission de la lumière (2) est conçu sous forme d'une fenêtre,
- le second dispositif de transmission de la lumière (2) est formé d'une fenêtre en verre, ou
- le second dispositif de transmission de la lumière (2) est formé d'une fenêtre en matière plastique.

14. Dispositif selon l'une quelconque des revendications 2 à 13, qui présente au moins une des caractéristiques suivantes :
- le troisième dispositif de transmission de la lumière (11) est conçu sous forme d'une fenêtre,
- le troisième dispositif de transmission de la lumière (11) est formé d'une fenêtre en verre, ou
- le troisième dispositif de transmission de la lumière (11) est formé d'une fenêtre en matière plastique.

15. Système d'entrée de lumière, notamment système de fenêtre, comprenant un dispositif selon au moins l'une des revendications précédentes.
